# EUROPEAN PATENT SPECIFICATION

(11) **EP 3 142 468 B1**
(45) Date of publication and mention of the grant of the patent: **11.04.2018**
(21) Application number: 15185124.3
(22) Date of filing: 14.09.2015
(51) Int. Cl.: H05K 1/02, H05K 1/18

(54) **FLEXIBLE PRINTED CIRCUIT BOARD AND METHOD OF FOLDING A FLEXIBLE PRINTED CIRCUIT BOARD**
FLEXIBLE LEITERPLATTE UND VERFAHREN ZUM FALTEN EINER FLEXIBLEN LEITERPLATTE
CARTE DE CIRCUIT IMPRIMÉ SOUPLE ET PROCÉDÉ DE PLIAGE D'UNE TELLE CARTE

(43) Date of publication of application: 15.03.2017
(73) Proprietor: TP Vision Holding B.V., 1097 JB Amsterdam (NL)
(72) Inventor: Bruyneel, Filip Marcel Denise, B-9052 Ghent (BE); Spaenhoven, Stefan Eugeen, B-9052 Ghent (BE); Delacroix, Danny Arnoldus Julomain, B-9052 Ghent (BE)
(74) Representative: DREISS Patentanwälte PartG mbB

(56) References cited:
- FR-A1- 2 853 447
- US-A1- 2008 242 126
- US-A1- 2010 220 046
- US-A1- 2013 153 273
- US-A1- 2014 111 684
- US-A1- 2014 301 047
- US-A1- 2015 117 001

## Description

### Field of the invention

The invention relates to a flexible printed circuit board.

The invention further relates to an electronic device comprising a flexible printed circuit board.

The invention also relates to a method of folding a flexible printed circuit board.

### Background of the invention

WO2010/133992 A2 discloses a flexible printed circuit board for controlling light emitting diodes (LEDs). The printed circuit boards comprised light emitting diode circuits and other circuitry including a driver for driving the light emitting diode circuits individually for providing ambient light for a display. Multiple flexible printed circuit boards are placed along edges of the display.

A drawback of this printed circuit board is that an L-shaped (flexible) printed circuit board needs to be used in the corners of the display and that various kinds of L-shaped (flexible) printed circuit boards need to be manufactured for various display sizes.

US 2010/220046 A1 discloses an illumination device which comprises at least one light module wherein the light module comprises a circuit board to which a plurality of groups of light sources are applied and a carrier on which the light module is fixed, is specified. A display apparatus comprising such an illumination device is also disclosed.

FR 2 853 447 A1 discloses a bendable conductive band supplying groups of electroluminescent diodes or lamps comprises many groups of main conductive sections or parts which are arranged endwise in rows on one another by cutting an unfolding a separated foil sheet.

US 2015/117001 A1 discloses a flexible circuit board, including a first insulation layer, a second insulation layer and a circuit layer, wherein the first insulation layer is attached to one side of the circuit layer and the second insulation layer is attached to the other side of the circuit layer, each of the first insulation layer and the second insulation layer is provided with a foldable portion along their length, the foldable portion of the first insulation layer is corresponding in position with the foldable portion of the second insulation layer, and the circuit layer includes a set of power wires and at least one lighting wire. And a method for manufacturing the flexible circuit board, and a LED flexible strip light are also disclosed.

### Summary

It is a first object of the description to provide a flexible printed circuit board, which can be used for various display sizes.

It is a second object of the description to provide an electronic device comprising a flexible printed circuit board which can be used for various display sizes.

It is a third object of the description to provide a method of folding a flexible printed circuit board, which enables said flexible printed circuit board to be used for various display sizes.

According to the description, the first object is realized in that the flexible printed circuit board comprises a flexible strip comprising an overlength area, said flexible strip being foldable substantially 180 degrees with a radius of substantially 0 mm in said overlength area, and a plurality of light emitting elements applied to said flexible strip outside said overlength area, each of said plurality of light emitting elements being connectable to a source of power external to said flexible printed circuit board, at least one of said plurality of light elements being positioned on one side of said overlength area and at least one of said plurality of lights elements being positioned on the other side of said overlength area.

With this flexible printed circuit board, it is not necessary to create different flexible printed circuit boards for the corners of a display depending on the size of the display. Either the same flexible printed circuit board with light emitting elements is used for corners of displays of different sizes or the same flexible printed circuit board without light emitting elements is soldered together with a flexible printed circuit board with an amount of light emitting elements that depends on the size of a display and used for a corner of this display. The flexible printed circuit board with the overlength area only has to be folded in a different way depending on the display size. The overlength area can be the same for different display sizes (only the folding will be different).

Said flexible printed circuit board may further comprise electrical contacts in said overlength area for enabling provision of protection against electromagnetic interference. Said electrical contacts may comprise solder dots. Preferably, printed circuit boards for controlling light emitting diodes are connected to the circuitry of the display device (e.g. the circuitry for supplying power and control signals) at a corner of the display. By placing electrical contacts in the overlength area, at least one of them can be connected to a signal ground of the display device, e.g. television, in the same location as the other connections. Electromagnetic interference can especially be a problem in case the printed circuit boards are applied along all four sides of the display. When a single layer flex strip is used, the solder dots for EMC will be on the same side of the flexible printed circuit board as the light emitting elements. To ensure a connection between the display device and the flexible printed circuit boards via the solder dots, the overlength area must be folded in such a way that the solder dots are facing the ground plate of the display device. At least one said plurality of light emitting elements may be connectable to a source of data external to said flexible printed circuit board and may be operative to change at least one of an intensity and color of said at least one of said plurality of light emitting elements in dependence on data received from said source of data. Although it is possible to develop a printed circuit board on which all light emitting elements always keep the same intensity and color, the use of a printed circuit board that adapts to user input or to the contents of an image displayed on a display, for example, is especially advantageous.

Said flexible strip may comprise a single layer of circuitry. By limiting the circuitry to one layer, it becomes easier to achieve the desired amount of flexibility.

Said flexible strip may further comprise a connector for connecting said flexible printed circuit board to an electronic device, e.g. to receive power from a source of power in the electronic device or to receive said data from a source of data in the electronic device. By mounting the connector on the flexible strip, it can be folded towards the inside of the electronic device in which it is incorporated for easy access to the connector.

Said flexible strip may further comprise a power converter, e.g. a DC/DC converter, for converting a power signal with a first voltage received from said source of power to a power signal with a second voltage for said light emitting elements. This allows a first flexible printed circuit board to be incorporated into a first electronic device to use light emitting elements requiring a first voltage and a second flexible printed circuit board to be incorporated into a second electronic device to use light emitting elements requiring a second voltage without modifying the circuitry of the electronic device (which comprises the source of power).

Said flexible strip may comprise a polyimide base film material. This material has the properties to achieve the desired amount of flexibility.

According to the description, the second object is realized in that the electronic device comprises the flexible printed circuit board of the description. Said electronic device may further comprise a display. Said light emitting elements may be operative to provide an ambient lighting effect behind said electronic device around said display. An ambient light effect behind said electronic device around said display provides a more immersive experience to viewers of said display and may reduce eyestrain.

According to the description, the third object is realized in that the method of folding a flexible printed circuit board comprises the steps folding a flexible printed circuit board between 0 and 90 degrees in said overlength area in a first direction into a first folded state and folding said flexible printed circuit board in said first folded state substantially 180 degrees in said overlength area into a second folded state. With this method, an L-shaped flexible printed circuit board can be folded. Since the flexible printed circuit board is folded twice, the light emitting elements remain on the same (top) side of the flexible printed circuit board and only the shape of the overlength area needs to be adapted to absorb the tolerances in the positions of the light emitting elements (display size dependent).

Said method may further comprise the step of incorporating said folded flexible printed circuit board into an electronic device. Said electronic device may comprise a display and at least one of said steps of folding said flexible circuit board in said overlength area may comprise folding said flexible circuit board at a position which depends on a size of at least one of said display and said electronic device. With this method, the same flexible printed circuit board can be used in corners of displays of various sizes by folding it differently depending on the display size.

Said method may further comprise the step of soldering said flexible printed circuit board to a further printed circuit board. By soldering said flexible printed circuit board to a further printed circuit board, the flexible printed circuit boards remain relatively thin, because connectors would be relatively thick, and any electronic device they are incorporated into can therefore also be made relatively thin.

### Brief description of the Drawings

These and other aspects of the description are apparent from and will be further elucidated, by way of example, with reference to the drawings, in which:
Fig.1 is a block diagram of an embodiment of the flexible printed circuit board of the description;
Fig.2 shows an example of the flexible printed circuit board of Fig.1 in a first folded state;
Fig.3 shows a first example of the flexible printed circuit board of

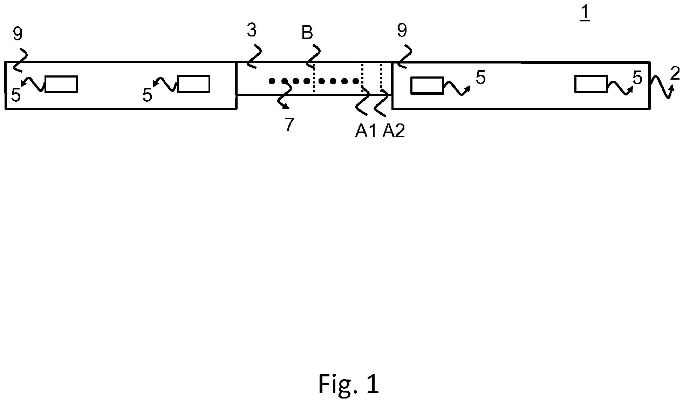

Fig.1 in a second folded state;

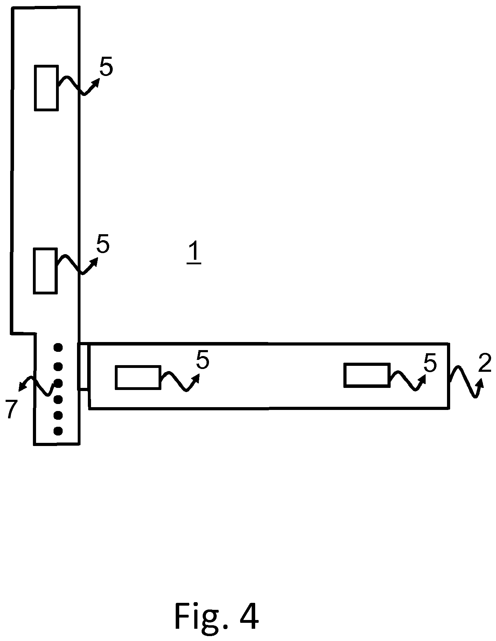

Fig.4 shows a second example of the flexible printed circuit board of
Fig.1 in a second folded state;

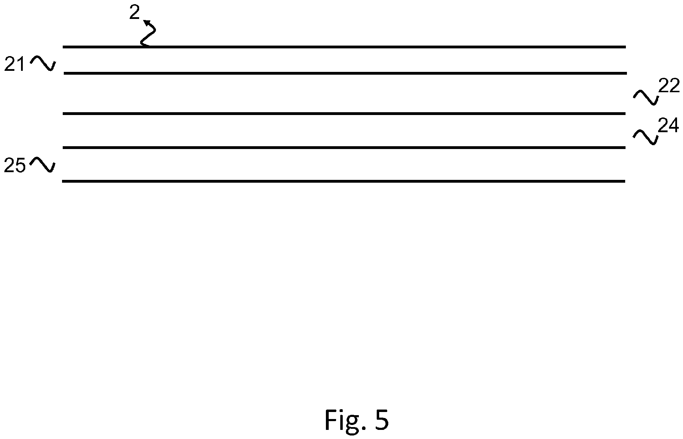

Fig.5 shows a cross section of an embodiment of the flexible strip of the description;

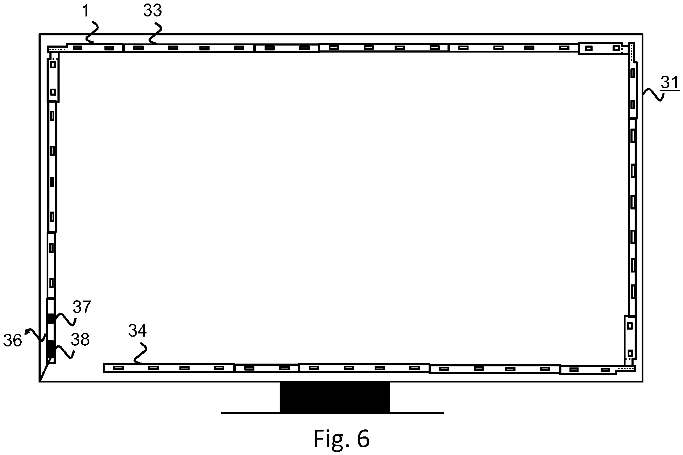

Fig.6 is a block diagram of a first embodiment of the electronic device of the description;

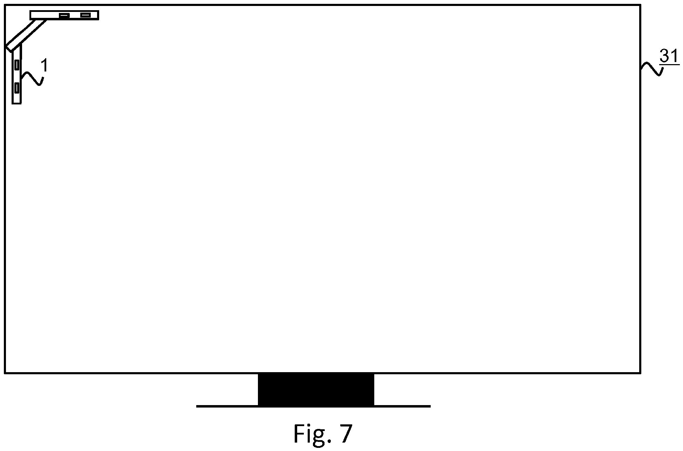

Fig.7 is a block diagram of a second embodiment of the electronic device of the description; and

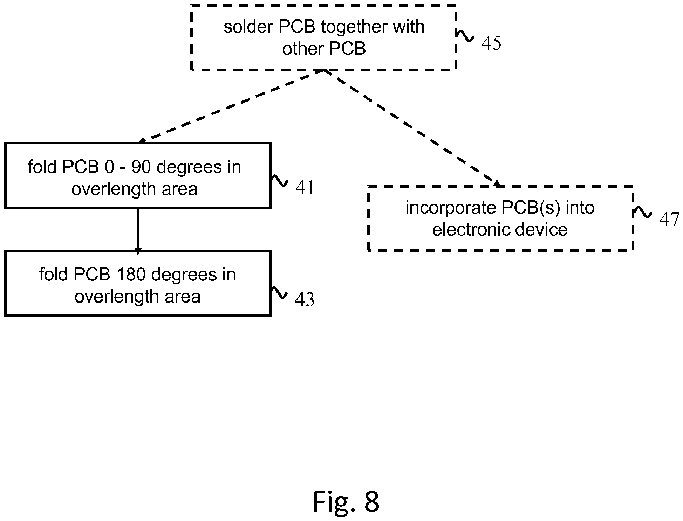

Fig.8 is a flow diagram of the method of the description.

Corresponding elements in the drawings are denoted by the same reference numeral.

### Detailed description of the Drawings

The flexible printed circuit board 1 comprises a flexible strip 2 and a plurality of light emitting elements 5, see Fig.1. The flexible strip 2 comprises an overlength area 3 and is foldable substantially 180 degrees with a radius of substantially 0 mm in the overlength area 3. The plurality of light emitting elements 5 have been applied to the flexible strip 2 outside the overlength area 3 in areas 9. Each of the plurality of light emitting elements 5 is connectable to a source of power (not shown) external to the flexible printed circuit board 1. At least one of the plurality of light elements 5 is positioned on one side of the overlength area 3 in a first area 9. At least one of the plurality of lights elements 5 is positioned on the other side of the overlength area 3 in a second area 9. The light emitting elements 5 may be LEDs, for example. Preferably, each LED has its own driver. In the embodiment shown in Fig. 1 , two light emitting elements 5 are shown at each side of the overlength area. The amount of light emitting elements 5 on each side can be varied. A flexible printed circuit board with an overlength area may be soldered together with two flexible printed circuit boards with light emitting elements 5 in order to obtain the flexible printed circuit board of Fig.1.

In the embodiment shown in Fig.1, the flexible printed circuit board 1 further comprises electrical contacts 7 in the overlength area 3 for enabling provision of protection against electromagnetic interference. The electrical contacts may be solder dots, for example. Preferably, at least one the plurality of light emitting elements 5 is connectable to a source of data (not shown) external to the flexible printed circuit board 1 and is operative to change at least one of an intensity and color of the at least one the plurality of light emitting elements 5 in dependence on data received from the source of data. This source of data may send control signals comprising user input or control signals generated based on user input, for example. Alternatively or additionally, this source of data may send control signals based on an analysis of images displayed on a display, for example. Such a source of data is present in Philips<™>Ambilight<™>televisions, for example. Preferably, the flexible strip 2 comprises only a single layer of circuitry. In order to limit the circuitry to one layer, the pinning of the light emitting elements needs to be designed so that they do not cross each other. Preferably, tracks should pass straight across the overlength area 3 limiting the cross-section of the conductor that needs to fold. Preferably, there are no components in the overlength area 3.

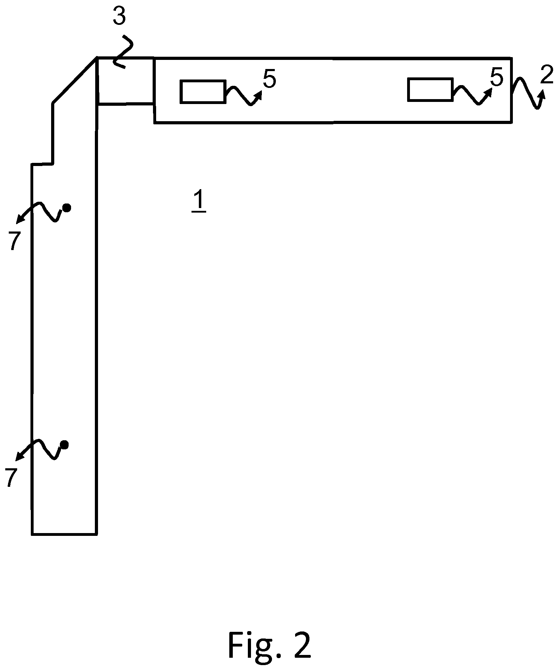

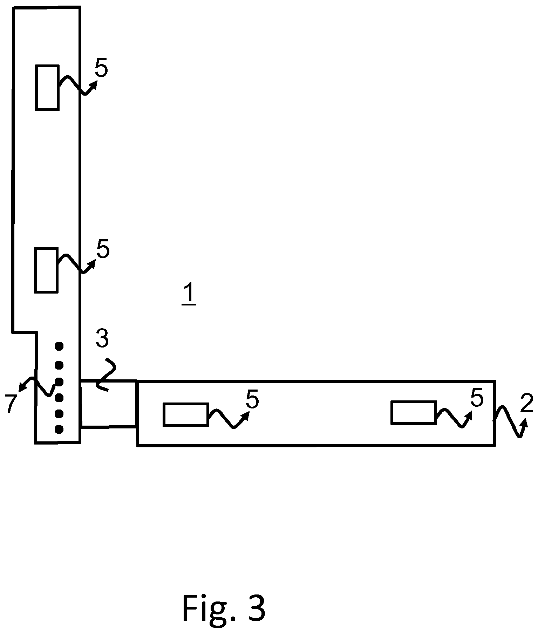

Fig. 2 shows the flexible printed circuit board 1 folded 90 degrees at a position A1 (see Fig.1) in the overlength area 3 in the left direction. Fig. 3 shows the flexible printed circuit board 1 from Fig.2 being folded 180 degrees at a position B (see Fig.1) in said overlength area 3. Fig. 4 shows the flexible printed circuit board 1 also being folded 180 degrees at a position B in said overlength area 3, but the flexible printed circuit board 1 shown in Fig. 4 was previously folded 90 degrees at a position A2 (see Fig.1) in the overlength area 3 in the left direction. When the flexible printed circuit board 1 is folded at positions A1 and B, the result of which is shown in Fig.3 , the nearest light emitting elements 5 are relatively far from the corner. When the flexible printed circuit board 1 is folded at positions A2 and B, the result of which is shown in Fig.4, the nearest light emitting elements 5 are relatively close to the corner. This allows the same flexible printed circuit board 1 to be used as a corner piece for areas, e.g. displays, of different sizes. Electrical contacts 7 may also be placed on the bottom side of areas 9, outside the overlength area 3, opposite the light emitting elements 5, to allow contact to a grounding plate.

A cross section of an embodiment of the flexible strip 2 is shown in Fig.5 . In this embodiment, the flexible strip 2 comprises a polyimide base film material 25, e.g. 12.5 micrometres thick. The flexible strip 2 further comprises a coverlay polyimide 21, e.g. 12 micrometres thick, a coverlay adhesive 22, e.g. 15 micrometres thick, and a layer of electro-deposited copper 24, e.g. 12 micrometres thick. The flexible strip should be thin enough, e.g. 51.5 micrometres thick, to be foldable substantially 180 degrees with a radius of substantially 0 mm.

The electronic device 31 comprises the flexible printed circuit board 1, see Fig. 6 . In an embodiment, the electronic device 31 further comprises a display. The electronic device 31 may be a television or monitor, for example, and may comprise the components typical for such electronic devices. The electronic device 31 may comprise an LCD or OLED display, for example. The light emitting elements 5 may be operative to provide an ambient lighting effect behind the electronic device around the display. Such an ambient light effect is known from Philips<™>Ambilight<™>televisions. Flexible printed circuit board 1 is attached to a (straight) further printed circuit board 33, which is itself attached to another (straight) printed circuit board, etc. The printed circuit boards can be soldered together to ensure that the electronic device does not increase in thickness too much. The number of printed circuit boards and light emitting elements varies per design and preferably depends on the size of the display. With a 55 inch display panel, 4 light emitting elements may be used at each side, 9 light emitting elements may be used at the top and 8 light emitting elements may be used at the bottom, for example.

In the embodiment of Fig. 6 , fifteen flexible printed circuit boards are soldered together. In an alternative embodiment, less flexible printed circuit boards may be soldered together, e.g. one per side. Alternatively, one flexible printed circuit board may be used for the entire electronic device 31 so that no soldering is necessary. Further printed circuit board 36 is a printed circuit board with a power (e.g. DC/DC) converter 37 and a connector 38 going to the electronic device 31 (e.g. carrying power and the control/data signal for the light emitting elements). Further printed circuit board 36 does not comprise any light emitting elements in the embodiment of Fig.6 . If further printed circuit board 36 would comprise one or more light emitting elements, it would normally not be possible to use it to turn around a corner, as it does not comprise an overlength area. However, it is possible to end with further printed circuit board 36 in a corner by folding back a part of the (flexible) printed circuit board 36 (a part that does not comprise the power converter 37 and connector 38) towards the inside of the electronic device 31. If the folded back part of the further printed circuit board 36 comprises one or more light emitting elements, it would normally not be possible to use these light emitting elements. In a similar manner, other printed circuit boards without an overlength area can also be used as last printed circuit board before a corner if it is not necessary to turn around the corner. For example, further printed circuit board 34 would have had to be folded back towards the inside of the electronic device 31 if it would have been longer. When the flexible strip 2 comprises electrical contacts 7 in the overlength area 3, at least one of the electrical contacts 7 can be connected to a signal ground in the electronic device 31 external to the flexible printed circuit board 1 to provide protection against electromagnetic interference.

In the embodiment of Fig. 6 , the flexible printed circuit board 1 in the corner was folded 90 degrees to the left and then 180 degrees to make a 90 degree corner. In the embodiment of Fig. 7 , the flexible printed circuit board 1 was folded 135 degrees to the left and then 180 degrees, twice, to first make a 45 degree turn at the left side and then make another 45 degree turn at the top side. So the flexible printed circuit board 1 was folded in total four times to make a 90 degree turn in two stages.

The method of folding a flexible printed circuit board 1, comprises a step 41 and a step 43, see Fig.8 . Step 41 comprises folding the flexible printed circuit board 1 between 0 and 90 degrees in the overlength area 3 in a first direction into a first folded state. Step 43 comprises folding the flexible printed circuit board 1 in the first folded state substantially 180 degrees in the overlength area 3 into a second folded state. In an embodiment, the method further comprises a step 47 of incorporating the folded flexible printed circuit board 1 into (a part of) an electronic device 31. Step 47 may comprise incorporating the folded flexible printed circuit board 1 into a back cover before or after mounting the back cover on the electronic device. The folded flexible printed circuit board 1 may be incorporated into the electronic device 31 with tape, by overmoulding or with screws or other fixations, for example.

In the same or in a different embodiment, the electronic device 31 comprises a display and at least one of the steps 41 and 43 comprises folding the flexible circuit board 1 at a position which depends on a size of at least one of the display and the electronic device 31. The flexible printed circuit boards can be incorporated into the electronic device 31 near the edges of the electronic device 31 or near the edges of the display, for example. In the same or in a different embodiment, the method further comprises a step 45 of soldering the flexible printed circuit board 31 to a further printed circuit board 33. For example, there may be three types of flexible printed circuit boards that are used: 1) a flexible printed circuit board with an overlength area (that is used to make corners), 2) a (straight) flexible printed circuit board with a plurality of light emitting elements and 3) a flexible printed circuit board with a connector and/or DC/DC power converter and/or other circuitry (except LEDs) going to the electronic device. Several variants of type 3 with different amounts of light emitting elements (e.g. 7, 10, 11 and 21) may exist. Which variant is (or which variants are) used typically depends on the size of the display or of the electronic device. Flexible printed circuit boards of the same type and/or of different types can be soldered together in step 45 to create a longer flexible printed circuit board 1. Step 45 is preferably carried out as first step of the method, but this is not required.

While the invention has been described in connection with preferred embodiments, it will be understood that modifications thereof within the principles outlined above will be evident to those skilled in the art, and thus the invention is not limited to the preferred embodiments but is intended to encompass such modifications. The invention resides in each and every novel characteristic feature and each and every combination of characteristic features. Reference numerals in the claims do not limit their protective scope. Use of the verb "to comprise" and its conjugations does not exclude the presence of elements other than those stated in the claims. Use of the article "a" or "an" preceding an element does not exclude the presence of a plurality of such elements.

'Means', as will be apparent to a person skilled in the art, are meant to include any hardware (such as separate or integrated circuits or electronic elements) or software (such as programs or parts of programs) which perform in operation or are designed to perform a specified function, be it solely or in conjunction with other functions, be it in isolation or in co-operation with other elements. The invention can be implemented by means of hardware comprising several distinct elements, and by means of a suitably programmed computer. The mere fact that certain measures are recited in mutually different dependent claims does not indicate that a combination of these measures cannot be used to advantage.

## Claims

1. A flexible printed circuit board (1), comprising:
a flexible strip (2) comprising an overlength area (3), said flexible strip (2) being foldable substantially 180 degrees with a radius of substantially 0 mm in said overlength area (3); and
a plurality of light emitting elements (5) applied to said flexible strip (2) outside said overlength area (3), each of said plurality of light emitting elements (5) for connection to a source of power external to said flexible printed circuit board (1), at least one of said plurality of light elements (5) being positioned on one side of said overlength area (3) and at least one of said plurality of lights elements (5) being positioned on the other side of said overlength area (3), **characterized in that** the flexible printed circuit board (1) is folded between 0 and 90 degrees in the overlength area (3) in a first direction into a first folded state; and that
the flexible printed circuit board (1) is folded in said first folded state substantially 180 degrees in said overlength area into a second folded state.

2. A flexible printed circuit board (1) as claimed in claim 1, further comprising electrical contacts (7) in said overlength area (3) for enabling provision of protection against electromagnetic interference.

3. A flexible printed circuit board (1) as claimed in claim 2, wherein said electrical contacts (7) comprise solder dots.

4. A flexible printed circuit board (1) as claimed in any of the preceding claims, wherein at least one said plurality of light emitting elements (5) is configured for a connection to a source of data external to said flexible printed circuit board (1) and is operative to change at least one of an intensity and color of said at least one of said plurality of light emitting elements (5) in dependence on data received from said source of data.

5. A flexible printed circuit board (1) as claimed in any of the preceding claims, wherein said flexible strip (2) comprises a single layer of circuitry.

6. A flexible printed circuit board (1) as claimed in any of the preceding claims, wherein said flexible strip (2) further comprises a connector (38) for connecting said flexible printed circuit board (1) to an electronic device (31).

7. A flexible printed circuit board (1) as claimed in any of the preceding claims, wherein said flexible strip (2) further comprises a power converter (37) for converting a power signal with a first voltage received from said source of power to a power signal with a second voltage for said light emitting elements (5).

8. An electronic device (31) comprising the flexible printed circuit board (1) of any of claims 1 to 7.

9. An electronic device (31) as claimed in claim 8, further comprising a display.

10. An electronic device (31) as claimed in claim 9, wherein said light emitting elements (5) are operative to provide an ambient lighting effect behind said electronic device around said display.

11. An electronic device (31) as claimed in any of claims 7 to 10, wherein said flexible strip (2) comprises electrical contacts (7) in said overlength area (3) and at least one of said electrical contacts (7) is connected to a signal ground in said electronic device (31) external to said flexible printed circuit board (1).

12. A method of folding a flexible printed circuit board, comprising the steps of:
folding (41) a flexible printed circuit board between 0 and 90 degrees in an overlength area in a first direction into a first folded state; and
folding (43) said flexible printed circuit board in said first folded state substantially 180 degrees in said overlength area into a second folded state.

13. A method as claimed in claim 12, further comprising the step of incorporating (47) said folded flexible printed circuit board into an electronic device.

14. A method as claimed in claim 13, wherein said electronic device comprises a display and at least one of said steps of folding said flexible circuit board in said overlength area comprises folding said flexible circuit board at a position which depends on a size of at least one of said display and said electronic device.

15. A method as claimed in any of claims 11 to 14, further comprising the step of soldering (45) said flexible printed circuit board to a further printed circuit board.

## Patentansprüche

1. Flexible gedruckte Schaltung (1), umfassend:
einen flexiblen Streifen (2), umfassend einen Überlängenabschnitt (3), wobei der flexible Streifen (2) im Wesentlichen um 180 Grad faltbar ist, wobei sich ein Radius von im Wesentlichen 0 mm in dem Überlängenabschnitt (3) befindet;
und eine Vielzahl von Leuchtelementen (5), die auf dem flexiblen Streifen (2) außerhalb des Überlängenabschnitts (3) aufgebracht sind, wobei jede Vielzahl von Leuchtelementen (5) an eine in Bezug auf die flexible gedruckte Schaltung (1) externe Stromversorgung angeschlossen ist, mindestens eine der Vielzahl von Leuchtelementen (5) auf einer Seite des Überlängenabschnitts (3) angeordnet ist und mindestens eine der Vielzahl von Leuchtelementen (5) auf der anderen Seite des Überlängenabschnitts (3) angeordnet ist,
**dadurch gekennzeichnet, dass** die flexible gedruckte Schaltung (1) in dem Überlängenabschnitt (3) zwischen 0 und 90 Grad in einer ersten Richtung in einen ersten Faltzustand gefaltet ist; und dass die flexible gedruckte Schaltung (1) in dem ersten Faltzustand in dem Überlängenabschnitt im Wesentlichen um 180 Grad in einen zweiten Faltzustand gefaltet ist.

2. Flexible gedruckte Schaltung (1) nach Anspruch 1, die in dem Überlängenabschnitt (3) zudem elektrische Kontakte (7) umfasst, welche einen Schutz gegen elektromagnetische Störungen ermöglichen.

3. Flexible gedruckte Schaltung (1) nach Anspruch 2, wobei die elektrischen Kontakte (7) Lötpunkte umfassen.

4. Flexible gedruckte Schaltung (1) nach einem der vorstehenden Ansprüche, wobei mindestens eine Vielzahl von Leuchtelementen (5) an eine in Bezug auf die flexible gedruckte Schaltung (1) externe Datenquelle angeschlossen ist und mindestens die Intensität oder die Farbe der mindestens einen Vielzahl von Leuchtelementen in Abhängigkeit von den von der Datenquelle empfangenen Daten verändert werden kann.

5. Flexible gedruckte Schaltung (1) nach einem der vorstehenden Ansprüche, wobei der flexible Streifen (2) eine einschichtige Schaltung umfasst.

6. Flexible gedruckte Schaltung (1) nach einem der vorstehenden Ansprüche, wobei der flexible Streifen (2) zudem einen Steckverbinder (38) für den Anschluss der flexiblen gedruckten Schaltung (1) an ein elektronisches Gerät (31) umfasst.

7. Flexible gedruckte Schaltung (1) nach einem der vorstehenden Ansprüche, wobei der flexible Streifen (2) zudem einen Stromrichter (37) umfasst, der dazu dient, ein von der Stromquelle empfangenes Leistungssignal mit einer ersten Spannung in ein Leistungssignal mit einer zweiten Spannung für die Leuchtelemente (5) umzuwandeln.

8. Elektronisches Gerät (31), das die flexible gedruckte Schaltung (1) nach einem der Ansprüche 1 bis 7 umfasst.

9. Elektronisches Gerät (31) nach Anspruch 8, das zudem ein Anzeigefeld umfasst.

10. Elektronisches Gerät (31) nach Anspruch 9, wobei die Leuchtelemente (5) in der Lage sind, hinter dem elektronischen Gerät um das Anzeigefeld herum einen Umgebungsbeleuchtungseffekt zu erzeugen.

11. Elektronisches Gerät (31) nach einem der Ansprüche 7 bis 10, wobei der flexible Streifen (2) in dem Überlängenbereich (3) elektrische Kontakte (7) umfasst und mindestens einer der elektrischen Kontakte (7) mit einer in Bezug auf die flexible gedruckte Schaltung (1) externen Signalmasse in dem elektrischen Gerät (31) verbunden ist.

12. Verfahren zum Falten einer flexiblen gedruckten Schaltung, das folgende Schritte umfasst:
Falten (41) einer flexiblen gedruckten Schaltung in einem Überlängenabschnitt in einer ersten Richtung zwischen 0 und 90 Grad in einen ersten Faltzustand;
Falten (43) der flexiblen gedruckten Schaltung in dem ersten Faltzustand in dem Überlängenbereich um im Wesentlichen 180 Grad in einen zweiten Faltzustand.

13. Verfahren nach Anspruch 12, das zudem den Schritt umfasst, in dem die gefaltete flexible gedruckte Schaltung in ein elektronisches Gerät eingefügt (47) wird.

14. Verfahren nach Anspruch 13, wobei das elektronische Gerät ein Anzeigefeld umfasst und mindestens einer der Schritte des Faltens der flexiblen gedruckten Schaltung in dem Überlängenbereich das Falten der flexiblen gedruckten Schaltung an einer Stelle umfasst, die von der Größe mindestens des Anzeigefeldes oder des elektronischen Geräts abhängt.

15. Verfahren nach einem der Ansprüche 11 bis 14, das zudem den Schritt umfasst, in dem die flexible gedruckte Schaltung auf eine weitere gedruckte Schaltung gelötet wird.

## Revendications

1. Plaquette de circuit imprimé flexible (1), comprenant:
une bande flexible (2) comprenant une zone de surlongueur (3), cette bande flexible (2) étant repliable d'essentiellement 180 degrés avec un rayon d'essentiellement 0 mm dans la zone de surlongueur (3), et
un ensemble d'éléments émetteurs de lumière (5) appliqués sur la bande flexible (2) à l'extérieur de la zone de surlongueur (3), chacun des éléments émetteurs de lumière de l'ensemble d'éléments émetteurs de lumière (5) pouvant être relié à une source d'énergie extérieure à la plaquette de circuit imprimé flexible (1), au moins l'un des éléments émetteurs de lumière (5) de l'ensemble d'éléments émetteurs de lumière étant positionné d'un côté de la zone de surlongueur (3) et au moins l'un des éléments émetteurs de lumière de l'ensemble d'éléments émetteurs de lumière (5) étant positionné de l'autre côté de la zone de surlongueur (3), **caractérisée en ce qu'**elle est repliée d'entre 0 et 90 degrés dans la zone de surlongueur (3) dans une première direction selon un premier état replié, et
dans ce premier état replié elle est repliée essentiellement de 180 degrés dans la zone de surlongueur selon un second état replié.

2. Plaquette de circuit imprimé flexible (1) conforme à la revendication 1, comprenant en outre dans la zone de surlongueur (3) des contacts électriques (7) pour permettre l'obtention d'une protection contre les interférences électromagnétiques.

3. Plaquette de circuit imprimé flexible (1) conforme à la revendication 2, dans laquelle les contacts électriques (7) comprennent des points de brasage.

4. Plaquette de circuit imprimé flexible (1) conforme à l'une quelconque des revendications précédentes, dans laquelle au moins l'un des éléments émetteurs de lumière (5) de l'ensemble d'éléments émetteurs de lumière est conformé pour permettre une liaison avec une source de données externes à la plaquette de circuit imprimé flexible (1), et susceptible de faire varier l'intensité et/ou la couleur de l'élément émetteur de lumière parmi l'ensemble d'éléments émetteurs de lumière (5) en fonction de données reçues à partir de la source de données.

5. Plaquette de circuit imprimé flexible (1) conforme à l'une quelconque des revendications précédentes, dans laquelle la bande flexible (2) comporte une seule couche de circuit.

6. Plaquette de circuit imprimé flexible (1) conforme à l'une quelconque des revendications précédentes, dans laquelle la bande flexible (2) comporte en outre un connecteur (38) pour permettre de connecter la plaquette de circuit imprimé flexible (1) à un dispositif électronique (31).

7. Plaquette de circuit imprimé flexible (1) conforme à l'une quelconque des revendications précédentes, dans laquelle la bande flexible (2) comporte en outre un convertisseur de puissance (37) permettant de transformer un signal de puissance ayant une première tension provenant de la source d'énergie en un signal de puissance ayant une seconde tension pour les éléments émetteurs de lumière (5).

8. Dispositif électronique (31) comprenant une plaquette de circuit imprimé flexible (1) conforme à l'une quelconque des revendications 1 à 7.

9. Dispositif électronique (31) conforme à la revendication 8, comprenant en outre un affichage.

10. Dispositif électronique (31) conforme à la revendication 9, dans lequel les éléments émetteurs de lumière (5) sont susceptibles de fournir un effet d'éclairage ambiant à l'arrière du dispositif électronique autour de l'affichage.

11. Dispositif électronique (31) conforme à l'une quelconque des revendications 7 à 10, dans lequel la bande flexible (2) comprend des contacts électriques (7) dans la zone de surlongueur (3) et au moins l'un des contacts électriques (7) est relié à une base de signal dans le dispositif électronique (31) externe à la plaquette de circuit imprimé flexible (1).

12. Procédé permettant de replier une plaquette de circuit imprimé flexible comprenant des étapes consistant à:
replier (41) une plaquette de circuit imprimé flexible de 0 à 90 degrés dans une première direction, dans une zone de surlongueur, selon un premier état replié, et
replier (43) la plaquette de circuit imprimé flexible se trouvant dans le premier état replié essentiellement de 180 degrés dans la zone de surlongueur selon un second état replié.

13. Procédé conforme à la revendication 12, comprenant en outre une étape consistant à incorporer (47) la plaquette de circuit imprimé flexible repliée dans un dispositif électronique.

14. Procédé conforme à la revendication 13, selon lequel le dispositif électronique comporte un affichage et au moins l'une des étapes consistant à replier la plaquette de circuit imprimé flexible dans la zone de surlongueur comprend une étape consistant à replier la plaquette de circuit imprimé flexible dans une position qui dépend de la dimension de l'affichage et/ou du dispositif électronique.

15. Procédé conforme à l'une quelconque des revendications 11 à 14, comprenant en outre une étape consistant à souder (45) la plaquette de circuit imprimé flexible sur une autre plaquette de circuit imprimé.
